# EUROPÄISCHE PATENTSCHRIFT

(11) **EP 1 254 512 B1**
(45) Veröffentlichungstag und Bekanntmachung des Hinweises auf die Patenterteilung: **17.09.2008**
(21) Anmeldenummer: 01905610.0
(22) Anmeldetag: 08.01.2001
(51) Int. Cl.: H03F 3/45, H03H 19/00

(54) **VERSTÄRKER- ODER FILTERSCHALTUNG IN "SWITCHED-CAPACITOR"-SCHALTUNGSTECHNIK UND VERFAHREN ZUR VERSTÄRKUNG ODER FILTERUNG VON SIGNALEN**
AMPLIFIER OR FILTER CIRCUIT IN SWITCHED CAPACITOR CIRCUIT LOGIC AND METHOD FOR AMPLIFYING OR FILTERING SIGNALS
CIRCUIT AMPLIFICATEUR OU FILTRE A CAPACITES COMMUTEES ET PROCEDE D'AMPLIFICATION OU DE FILTRAGE DE SIGNAUX

(30) Priorität: 21.01.2000 DE 10002598
(43) Veröffentlichungstag der Anmeldung: 06.11.2002
(73) Patentinhaber: Infineon Technologies AG, 81669 München (DE)
(72) Erfinder: SAUERBREY, Jens, 82024 Taufkirchen (DE)
(74) Vertreter: Viering, Jentschura & Partner
(86) Internationale Anmeldenummer: PCT/DE2001/000034
(87) Internationale Veröffentlichungsnummer: WO 2001/054270

(56) Entgegenhaltungen:
- EP-A- 0 689 286
- EP-A- 0 836 274
- US-A- 4 987 383
- BASCHIROTTO A ET AL: "A 1-V 1.8-MHZ CMOS SWITCHED-OPAMP SC FILTER WITH RAIL-TO-RAIL OUTPUT SWING" IEEE JOURNAL OF SOLID-STATE CIRCUITS,US,IEEE INC. NEW YORK, Bd. 32, Nr. 12, 1. Dezember 1997 (1997-12-01), Seiten 1979-1986, XP000767447 ISSN: 0018-9200
- S L WONG AND C A T SALAMA: "A SWITCHED DIFFERENTIAL OP-AMP WITH LOW OFFSET AND REDUCED 1/F NOISE" IEEE TRANSACTIONS ON CIRCUITS AND SYSTEMS, Bd. CAS, Nr. 33, 1. November 1986 (1986-11-01), Seiten 1119-1126, XP002168676 US, IEEE INC. NEW YORK

## Beschreibung

Die vorliegende Erfindung betrifft eine Verstärker- oder Filterschaltung in "Switched-Capacitor"-Schaltungstechnik sowie ein Verfahren zur Verstärkung oder Filterung von Signalen mit "Switched-Capacitor"-Schaltungen.

Die vorliegende Erfindung dient zur Verwendung in der "Switched-Opamp"-Schaltungstechnik, einer speziellen Form der "Switched-Capacitor"-(SC)-Schaltungstechnik. Diese Schaltungstechnik ist beispielsweise in M. Steyart, "Switched-Opamp, a Technique for Realizing full CMOS Switched-Capacitor Filters at Very Low Voltages", ESSCIRC 1993 sowie Andrea Baschirotto, Rinaldo Castello und F. Montechi "Design strategy for low-voltage "Switched-Capacitor"-Schaltungstechnik circuits", Electronic Letters, Vol. 30, No. 5, 3rd March 1994 und A. Baschirotto, R. Castello, "A 1V 1.8 MHz CMOS Switched - Opamp SC Filter with Rail-to-Rail output swing", IEEE, JSSC, Vol. 32, No. 12, December 1997 eingehend beschrieben. Diese Schaltungstechnik wird hauptsächlich für sehr geringe Versorgungsspannungen verwendet. Die Summe der Einsatzspannungen von p-MOS und n-MOS Transistoren ist in diesen Einsatzfällen unter Umständen größer als die Betriebsspannung. Daher ist ein Schalterbetrieb selbst mit "Transmission-Gates" nicht mehr über den gesamten Bereich der Versorgungsspannung möglich. Eine Weiterentwicklung der "Switched-Capacitor"-Schaltungstechnik, die "Switched-Opamp"-Technik verschiebt die Signalpegel auf solche Werte, bei denen ein Schalterbetrieb der Transistoren möglich ist, oder ersetzt, sofern eine Signalpegelverschiebung nicht möglich ist, Schalter durch abschaltbare Operationsverstärker.

Ein verbleibender Schwachpunkt dieser Schaltungstechnik liegt im Eingang der Schaltung. Hier muß das Eingangssignal mit einem Switch geschaltet werden, der nicht ersetzt werden kann.

Im Stand der Technik wurden dafür bisher folgende Lösungen angegeben:

Gemäß Vinzenzo Peluso, et al., "A 900mV 40-µW ΔΣ Modulator with 77dB Dynamic Range", ISSCC98, pp. 68-69, 1998 besteht eine Lösung darin, daß mit sehr geringen Eingangsamplituden gearbeitet wird. Sehr kleine Signalpegel sind jedoch ungünstig im Bezug auf das Rauschen.

Eine weitere Lösung gemäß dem Stand der Technik ergibt sich aus Jesper Steengaard, "Bootstrapped Low-Voltage Analog Switches", Proceedings for the 1999 IEEE International Symposium on Circuits and Systems. IEEE May/June 1999. Gemäß diesem Stand der Technik wird eine lokale Gatespannungsüberhöhung bei den Eingangs-Switches vorgesehen. Ob diese Lösung aber überhaupt möglich ist, hängt sehr stark von dem Grenzwert der jeweiligen Technologie ab.

Weiterhin sind aus DE 42 18 533 C2 und DE 34 41 476 C2 "switched-capacitor"-Schaltungen bekannt mit einem Opterationsverstärker, die jedoch lediglich "floatend" schaltbar sind.

Aufgabe der vorliegenden Erfindung ist es daher, eine Verstärker- oder Filterschaltung und ein Verfahren zur Verstärkung oder Filterung von Signalen anzugeben, bei dem die Vorteile der "Switched-Opamp"-Technik genutzt werden können, ohne daß die Probleme mit den Schaltern am Eingang der Schaltung auftreten.

Erfindungsgemäß kann diese Aufgabe durch eine Verstärkerschaltung in "Switched-Capacitor"-Schaltungstechnik gelöst werden, die mit einem schaltbaren Operationsverstärker versehen ist.

Erfindungsgemäß kann die vorliegende Aufgabe auch durch eine Filterschaltung in "Switched-Capacitor"-Schaltungstechnik gelöst werden, wobei dieser Filterschaltung eingangsseitig ein Verstärker mit einem abschaltbaren Operationsverstärker vorgeschaltet ist.

Ebenso kann die erfindungsgemäße Aufgabe dadurch gelöst werden, daß der Verstärker- oder Filterschaltung eingangsseitig ein mit Widerständen derart beschalteter, abschaltbarer Operationsverstärker vorgeschaltet ist.

Vorzugsweise wird bei allen diesen Schaltungen der Betragswert der Verstärkung der Eingangsstufe ≥1 gewählt.

Die Widerstände für die Beschaltung des Operationsverstärkers werden dabei vorzugsweise aus Poly-Silizium ausgeführt.

Schließlich kann die erfindungsgemäße Aufgabe noch durch ein Verfahren zur Verstärkung oder Filterung von Signalen gelöst werden, wobei die Eingangssignale dieser Schaltungen zuerst einer Eingangsstufe mit abschaltbarem Operationsverstärker zugeführt werden, die den Eingangs-Gleichspannungswert auf einen solchen Wert verschiebt, der vom Eingangsschalter der folgenden Stufe normalerweise nicht verarbeitet werden könnte.

Im folgenden wird die Erfindung anhand der beigefügten Zeichnungen im einzelnen erläutert. Es zeigen:
- Fig. 1: eine "Switched-Opamp"-Filterschaltung gemäß dem Stand der Technik;
- Fig. 2: eine "Switched-Opamp"-Filterschaltung, der eine erfindungsgemäße Eingangsverstärkerstufe mit einem schaltbarem Operationsverstärker mit angepaßter Gleichsignalpegelverschiebung in "Switched-Capacitor"-Technik vorgeschaltet ist; und
- Fig. 3: eine Filterschaltung, der erfindungsgemäß eine Verstärkerschaltung mit einem Operationsverstärker mit angepaßter Gleichsignalpegelverschiebung für zeitkontinuierlichen Betrieb vorgeschaltet ist.

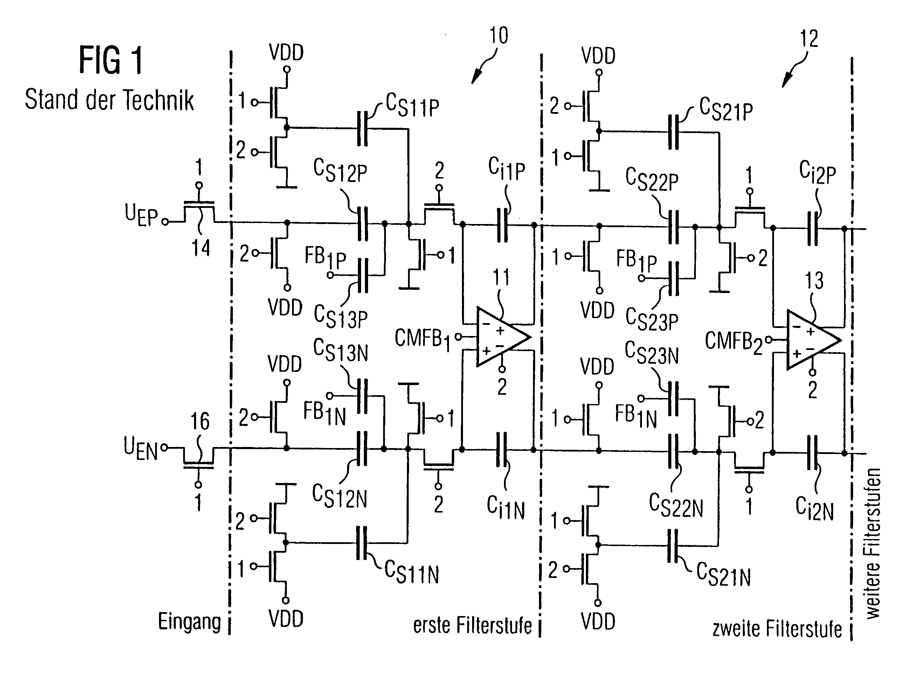

Fig. 1 zeigt eine typische "Switched-Opamp"-Filterschaltung, die mehrere Filterstufen umfaßt. Dargestellt ist eine erste Filterstufe 10 und eine zweite Filterstufe 12. Problematisch sind hier die beiden Transistorschalter 14, 16 an den Eingängen UEP und UEN.

Für sämtliche in den Figuren 1 bis 3 dargestellte Schaltungen sollen folgende Parameter gelten:
1. Die Versorgungsspannung beträgt 1V (VDD=1V; VSS=0V).
2.Die Einsatzspannung der Transistoren beträgt ca. 0.6V, daher können nur Spannungen zwischen 0V und 0,3V sowie 0,7V und 1V geschaltet werden. Transmission-Gates und Rail-to-Rail Eingangsstufen sind daher nur mit unvertretbarem Aufwand realisierbar.
3.Die Eingangsstufe des OPV besteht aus 2 p-MOS Transistoren und kann einen Common-Mode-Pegel zwischen 0V und 0,3V verarbeiten.
4.Die Ausgangsstufe des OPV hat einen Common-Mode-Pegel von 0,5V und kann im Bereich zwischen 0,2V und 0,8V arbeiten.
5.Liegt das Steuersignal am OPV an, ist dessen Ausgang eingeschaltet. Liegt es nicht an, ist der Ausgang entweder hochohmig oder dessen Stromzuführung nach VSS hochohmig.
6.Liegt die jeweilige Taktphase ("1" oder "2") an einem Transistor an, leitet dieser.

Fig. 1 zeigt den Eingang und die ersten zwei Stufen einer typischen "Switched-Opamp"-Filterschaltung. Die Common-Mode-Eingangsspannung der Operationsverstärker liegt typischerweise auf VSS. Die Common-Mode-Ausgangsspannung beträgt 0,5V. Die Ausgangsamplitude beider Operationsverstärker 11 und 13 beträgt 0,6V Spitze-Spitze pro Zweig. Dieser Spannungswert kann durch entsprechende Skalierung in allen Stufen erreicht werden. Ein Problem stellen die als Schalter dienenden MOS-Transistoren 14, 16 am Eingang dar. Unabhängig davon, ob N- oder P-Schalter verwendet werden, muß die Amplitude hier auf 0,3V Spitze-Spitze pro Zweig skaliert werden. Für die o.g. Voraussetzungen ergibt sich hier ein Eingangsspannungsbereich zwischen 0V und 0,3V (0,3V Spitze-Spitze pro Zweig bei 0,15V Common-Mode-Eingangspegel).

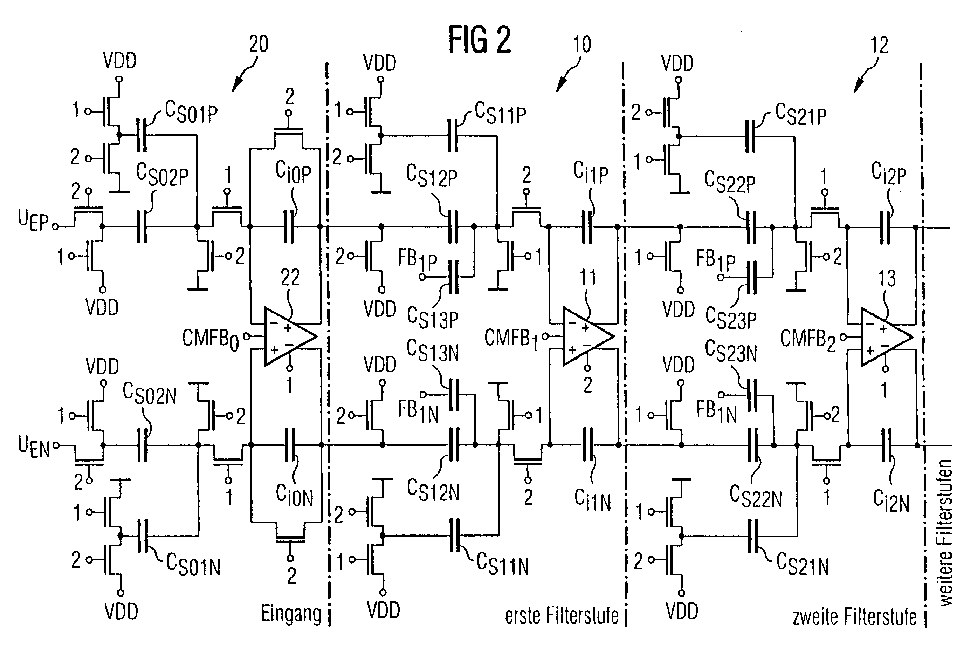

Fig. 2 zeigt eine Ausführungsform einer erfindungsgemäß zusätzlich vorgesehenen Eingangsstufe 20. Diese besteht aus einer zusätzlichen Verstärkerschaltung in "Switched-Capacitor"-Technik. Der zusätzliche Operationsverstärker 22 ist in der gleichen Weise wie die weiteren Operationsverstärker 11, 13 der Filterstufe nach Art der "Switched-Opamp"-Technik schaltbar. Vorzugsweise wird die Verstärkung dieses Operationsverstärkers 22 so gewählt, daß am Eingang der ersten Filterstufe 10 eine differentielle Spannung von ≤ 0,6V anliegt. Beträgt das differentielle Eingangssignal zwischen UEP und UEN beispielsweise 60mV (Spitze-Spitze pro Zweig bei 0V-Common-mode-Eingangspegel), so wird die Eingangsstufe 20 vorzugsweise so dimensioniert, daß sie eine Verstärkung von 10 bewirkt.

Bei der dabei auftretenden maximalen negativen Eingangsspannung von 30mV ist noch keine Beeinflussung durch Diodenleckströme zu erwarten. Andererseits kann der Common-mode-Eingangspegel auch etwas erhöht werden, beispielsweise auf +30mV.

Um bei größeren Verstärkungen ungünstige (d.h. sehr große) Kapazitätsverhältnisse zu vermeiden, können vorteilhafterweise mehrere solcher erfindungsgemäßer Eingangsstufen 20 in Serie geschaltet werden. Auch die maßvolle Einbeziehung des Eingangskondensators der ersten Filterstufe 10 ist natürlich sinnvoll, um eine optimale kapazitive Last zu erzielen. In dem dargestellten Ausführungsbeispiel handelt es sich dabei um die Kondensatoren C_{S12P} und C_{S12N}.

Die beschriebene Eingangsstufe eignet sich sinngemäß auch für Single-ended Schaltungen.

Diese Lösung gemäß Fig. 2 kann angewendet werden, wenn das Signal verstärkt werden soll. Wie in Fig. 2 dargestellt, wird hierzu also ein Verstärker in "Switched-Capacitor"-Technik mit einem geschalteten Operationsverstärker 22 modifiziert. Dieser modifizierte "Switched-Capacitor"-Verstärker 20 wird mit dem Eingang der ersten Filterstufe 10 des "Switched-Opamp"-Filters verbunden.

Die Verstärkung wird dabei bewußt nicht in der ersten Filterstufe 10 vorgenommen. Eine sehr hohe Verstärkung würde hier einerseits zu einer sehr hohen Eingangskapazität führen. Außerdem ist es vom Flächenbedarf wesentlich günstiger, mehrere oben beschriebene Verstärkerstufen mit niedrigerer Verstärkung hintereinander zu schalten (Flächenbestimmend sind die Kondensatoren, das Kapazitätsverhältnis bestimmt die Verstärkung und es gibt ein Rauschlimit hinsichtlich der Verringerung der Kapazitätswerte).

In der Ausführungsform gemäß Fig. 2 wird also eine "Switched-Capacitor"-Verstärkungsstufe durch Einführen des schaltbaren Operationsverstärkers 22 an die "Switched-Opamp"-Schaltungstechnik angepaßt, so daß diese als Vorverstärkerstufe das Problem der Eingangsschalter 14, 16 bei der "klassischen" "Switched-Opamp"-Schaltungstechnik gemäß Fig. 1 lösen kann.

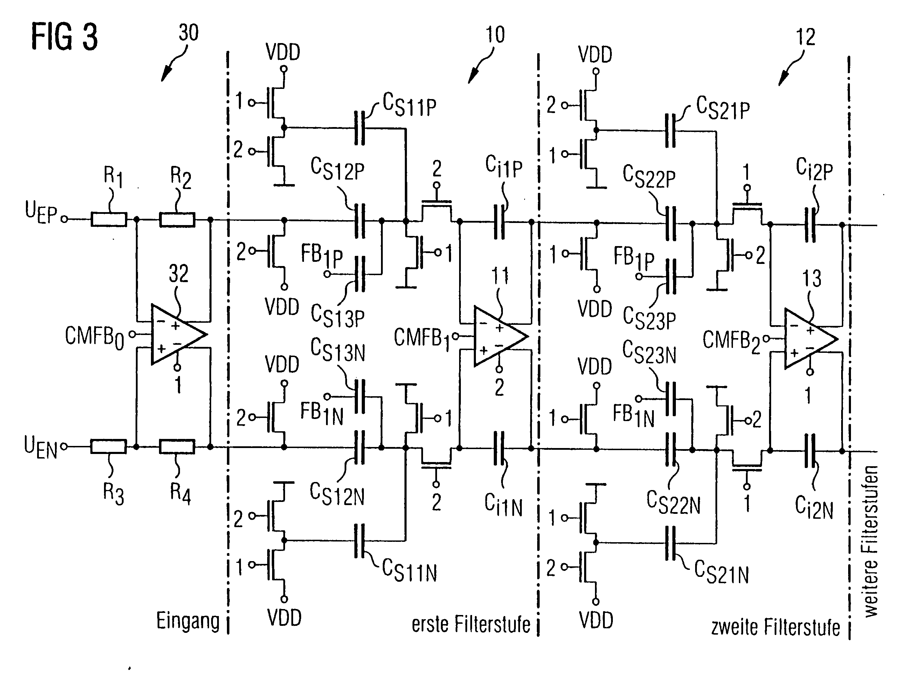

Fig. 3 zeigt eine andere erfindungsgemäße Ausführungsform für eine hier mit 30 bezeichnete Eingangsstufe, die wiederum der ersten Filterstufe 10 der "Switched-Opamp"-Filterschaltung der Fig. 1 vorgeschaltet ist. Diese Eingangsstufe 30 besteht ebenfalls aus einem zusätzlichen Operationsverstärker 32. Dieser ist jedoch hier mit vier Widerständen R₁ ... R₄ beschaltet. Diese Widerstände können vorzugsweise als "Poly-Silizium"-Widerstände ausgeführt sein.

Der zusätzliche Operationsverstärker 32 ist in der gleichen Weise wie die Operationsverstärker 11, 13 der Filterstufen 10, 12 in "Switched-Opamp"-Technik schaltbar. Wählt man R₁ = R₂ und R₃ = R₄, so ist die Verstärkung der Eingangsstufe 30 - 1. Eine Eingangsspannung von 0,6V Spitze-Spitze ergibt somit wiederum eine Eingangsspannung von 0,6V Spitze-Spitze am Eingang der ersten Filterstufe 10. In dem Ausführungsbeispiel der Fig. 3 kann die Eingangsamplitude somit verdoppelt werden, weil bei der konventionellen Eingangsstufe gemäß dem Stand der Technik (Fig. 1) nur eine Eingangsspannung von 0,3V Spitze-Spitze möglich gewesen wäre.

Verwendet man einen Common-Mode-Eingangspegel von 0V (z.B. durch kapazitive Kopplung), so beträgt die Common-Mode-Eingangsspannung des Operationsverstärkers 32 0,25V. Dieser Common-Mode-Pegel ist mit einer P-MOS Eingangsstufe gut zu verarbeiten.

Die bei einem Common-Mode-Eingangspegel von 0V auftretende maximale negative Spannung von -0,3V liegt dabei an einem Widerstand, der beispielsweise als Poly-Silizium-Widerstand ausgeführt werden kann, und bewirkt daher keine Leckströme (d.h. es wird keine parasitäre Diode in Durchlaßrichtung mit Spannung beaufschlagt).

Vorteilhaft kann diese Schaltung auch zur Signalverstärkung eingesetzt werden. In diesem Fall ist R₂ > R₁. Als Quelle dient hier z.B. ein differentielles Mikrofon, welches z.B. wiederum gegen VSS geschaltet ist. Je höher die Verstärkung gewählt wird, desto geringer ist die sich daraus ergebende Common-Mode-Eingangsspannung des Operationsvestärkers.

Die beschriebene Eingangsstufe eignet sich sinngemäß auch für Single-ended Schaltungen.

Gemäß dieser in Fig. 3 dargestellten Ausführungsform der Erfindung wird das Eingangssignal nicht direkt, sondern über einen schaltbaren Operationsverstärker 32 an den Eingang der ersten Filterstufe 10 in "Switched-Opamp"-Technik angeschlossen.

Bei dieser erfindungsgemäßen Lösung gemäß Fig. 3 wird also eine Verstärkerstufe 30 durch Einführung eines schaltbaren Operationsverstärkers 32 mit angepaßter Gleichsignalpegelverschiebung an die "Switched-Opamp"-Schaltungstechnik angepaßt.

## Patentansprüche

1. Elektronische Schaltung mit einer Schaltung in "Switched-Opamp"-Schaltungstechnik, und mit einer an einem Eingang der Schaltung in "Switched-Opamp"-Schaltungstechnik angeschlossenen nicht-integrierenden Verstärkerschaltung mit einem schaltbaren Operationsverstärker (22; 32).

2. Elektronische Schaltung nach Anspruch 1,
bei der die Schaltung in "Switched-Opamp"-Schaltungstechnik eingerichtet ist als Verstärkerschaltung.

3. Elektronische Schaltung nach Anspruch 1,
bei der die Schaltung in "Switched-Opamp"-Schaltungstechnik eingerichtet ist als Filterschaltung.

4. Elektronische Schaltung nach Anspruch 3,
bei welcher der abschaltbare Operationsverstärker (22; 32), welcher der Filterschaltung (10) eingangsseitig vorgeschaltet ist, mit ohmschen Widerständen (R₁... R₄) derart beschaltet ist, dass der Betragswert der Verstärkung dieser Eingangsstufe (30) > 1 ist.

5. Elektronische Schaltung nach Anspruch 4,
bei der dem vorgeschalteten Operationsverstärker (22 ;32) die Eingangssignale über eine kapazitive oder resistive Kopplung zuführbar sind..

6. Elektronische Schaltung nach Anspruch 4 oder 5,
bei der die ohmschen Widerstände (R₁ ... R₄) aus Poly-Silizium sind.

7. Verfahren zur Verstärkung oder Filterung von Signalen mit "Switched-Opamp"-Schaltungen, die mit sehr niedrigen Spannungen versorgt werden, bei dem die Eingangssignale dieser Schaltungen zuerst einer nicht-integrierenden Eingangsstufe mit abschaltbaren Operationsverstärker zugeführt werden, die den Eingangsgleichspannungswert auf einen solchen Wert verschiebt oder verstärkt, der vom Eingangsschalter der folgenden Stufe normalerweise nicht verarbeitet werden könnte.

## Claims

1. An electronic circuit comprising a circuit in "Switched-Opamp" circuit technology, and comprising a non-integrating amplifier circuit, comprising a switchable operational amplifier (22; 32), being connected to an input of the circuit in "Switched-Opamp" circuit technology.

2. The electronic circuit as claimed in claim 1,
wherein the circuit in "Switched-Opamp" circuit technology is configured as an amplifier circuit.

3. The electronic circuit as claimed in claim 1,
wherein the circuit in "Switched-Opamp" circuit technology is configured as a filter circuit.

4. The electronic circuit as claimed in claim 3,
wherein the operational amplifier (22; 32) which can be switched off and which is connected upstream the input of the filter circuit (10) is connected to ohmic resistors (R₁...R₄) such that the absolute value of the gain of this input stage (30) is > 1.

5. The electronic circuit as claimed in claim 4,
wherein the input signals can be supplied to the operational amplifier (22; 32) connected upstream using a capacitive coupling or a resistive coupling.

6. The electronic circuit as claimed in claim 4 or 5,
wherein the ohmic resistors (R₁...R₄) are made of polysilicon.

7. A method for amplifying or filtering signals using "Switched-Opamp" circuits supplied with very low voltages, wherein the input signals of these circuits are first supplied to a non-integrating input stage comprising an operational amplifier which can be switched off, wherein the non-integrating input stage shifts or amplifies the input direct current voltage value to such a value that could normally not be processed by the input switch of the following stage.

## Revendications

1. Circuit électronique comprenant un circuit en technique de circuit "Switched-Opamp" et un circuit amplificateur non intégré, qui est raccordé à une entrée du circuit en technique de circuit "Switched-Opamp" et qui a un amplificateur ( 22 ; 32 ) opérationnel commutable.

2. Circuit électronique suivant la revendication 1,
dans lequel le circuit en technique de circuit "Switched-Opamp" est aménagé en circuit amplificateur.

3. Circuit électronique suivant la revendication 1,
dans lequel le circuit en technique de circuit "Switched-Opamp" est aménagé en circuit de filtre.

4. Circuit électronique suivant la revendication 3,
dans lequel l'amplificateur ( 22 ; 32 ) opérationnel commutable en amont duquel, du côté de l'entrée, est monté le circuit ( 10 ) de filtre, est mis en circuit avec des résistances ( R1 ... R4 ) ohmiques de façon à ce que la valeur absolue de l'amplification de cet étage ( 30 ) d'entrée soit supérieure à 1.

5. Circuit électronique suivant la revendication 4,
dans lequel les signaux d'entrée peuvent être envoyés à l'amplificateur ( 22 ; 32 ) opérationnel monté en amont par un couplage capacitif ou résistif.

6. Circuit électronique suivant la revendication 4 ou 5,
dans lequel les résistances ( R1 à R4 ) ohmiques sont en polysilicium.

7. Procédé d'amplification ou de filtrage de signaux par des circuits "Switched-Opamp", qui sont alimentés en des tensions très basses, dans lequel on envoie les signaux d'entrée de ces circuits d'abord à un étage d'entrée non intégré, ayant des amplificateurs opérationnels commutables qui décalent ou amplifient la valeur de tension continue d'entrée à une valeur telle qu'elle ne peut plus être traitée normalement par le commutateur d'entrée de l'étage suivant.
